# EUROPÄISCHE PATENTSCHRIFT

(11) **EP 2 852 058 B1**
(45) Veröffentlichungstag und Bekanntmachung des Hinweises auf die Patenterteilung: **13.06.2018**
(21) Anmeldenummer: 14184522.2
(22) Anmeldetag: 12.09.2014
(51) Int. Cl.: H03K 17/60, G06F 1/32

(54) **Vorrichtung zum Aktivieren eines elektronischen Gerätes, insbesondere eines Steuergerätes in einem Fahrzeug**
Device for activating an electronic device, in particular a control unit in a vehicle
Dispositif d'activation d'un appareil électronique, notamment d'un appareil de commande dans un véhicule

(30) Priorität: 17.09.2013 DE 102013218627
(43) Veröffentlichungstag der Anmeldung: 25.03.2015
(73) Patentinhaber: Continental Automotive GmbH, 30165 Hannover (DE)
(72) Erfinder: Ferger, Andreas, 65812 Bad Soden (DE); Sichert, Jochen, 35428 Cleeberg (DE)

(56) Entgegenhaltungen:
- DE-A1-102008 013 243
- DE-B3- 10 330 451

## Beschreibung

Die Erfindung betrifft eine Vorrichtung zum Aktivieren eines elektronischen Geräts, insbesondere eines Steuergeräts in einem Fahrzeug, das von einem Ruhezustand in einen Betriebszustand versetzbar ist, bei dem das Gerät von einem Energiespeicher versorgt wird.

Um in der nutzungsfreien Zeit die Leistungsaufnahme eines elektronischen Gerätes, z. B. einer Motorsteuerung oder ECU zu senken, verfügen einige Geräte über einen Bereitschafts-Betriebsmodus, in dem einige oder alle Nutzfunktionen deaktiviert sind. Damit diese Geräte aus dem Bereitschaftsbetrieb bzw. Ruhezustand für ein möglichst sofortiges Weiterarbeiten schnell wieder aktiviert werden können, besitzen sie so genannte interne elektronische Wegschaltungen. Da jedoch die Notwendigkeit besteht, zumindest die Wegschaltungen zur Verarbeitung der Wecksignale aktiviert zu lassen, verbraucht das Gerät im Bereitschaftsbetrieb weiterhin elektrische Energie. Wird ein Gerät über einen Energiespeicher, z. B. einer Batterie oder einem Akkumulator mit Energie versorgt, führt dies zu einer ständigen Entladung des Energiespeichers.

Aus der DE 103 30 451 B3 ist eine Vorrichtung zum Wecken eines Steuergerätes bekannt, bei dem über Bedienschalter und eine Ansteuerschaltung die Stromversorgung an das Steuergerät gelegt wird. Dabei kann beispielsweise ein Bedienschalter durch eine Kraftfahrzeugtür betätigt werden und die Ansteuerschaltung versorgt ein Türsteuergerät, das wiederum andere Steuergeräte ansprechen kann. Bei dieser bekannten Vorrichtung ist in Reihe mit den Bedienschaltern eine Impulserzeugerstufe mit einem Mittenabgriff geschaltet, wobei der Mittenabgriff mit der Steuerelektrode eines Transistors gegebenenfalls über weitere Bauelemente verbunden ist. Dieser Transistor ist wiederum mit der Steuerelektrode eines weiteren Transistors verbunden, der den Versorgungsstrom für das zu weckende Steuergerät durchschaltet. Weiterhin ist eine Selbsthalteschaltung vorgesehen, die den Durchschaltzustand der beiden Transistoren aufrecht erhält, auch wenn die Impulserzeugerstufe keinen Impuls erzeugt.

Die DE 10 2008 013 243 A1 beschreibt eine Aufweckschaltung, bei der ein erstes Schaltungsteil auf eine Anstiegsflanke ein erstes Triggersignal ausgibt, und ein zweites Schaltungsteil auf eine Abstiegsflanke ein zweites Triggersignal ausgibt, und diese beiden Triggersignale durch einen Schalttransistor zu einem Aufwecksignal für nachgeordnete elektronische Baugruppen geformt wird.

Die DE 10 2007 055 231 A1 beschreibt eine Vorrichtung zum Wecken eines Steuergerätes, wobei eine Steuerschaltung zwischen der Stromversorgung und dem Steuergerät geschaltet ist, wobei das Steuergerät dazu eingerichtet ist, eine Energieverwaltungsschaltung in wenigstens einem ersten Zustand elektrisch von der Energieversorgung zu trennen und die Energieverwaltungsschaltung in wenigstens einem zweiten Zustand und beim Betätigen der Einschalttaste mit dem Energiespeicher zu verbinden. Dabei verbraucht die Steuerschaltung jedoch immer noch eine gewisse Energie.

Ausgehend vom Stand der Technik liegt der Erfindung die Aufgabe zugrunde, eine Vorrichtung zum Aktivieren eines elektronischen Gerätes, insbesondere eines Steuergerätes, bei dem einige oder alle Nutzfunktionen temporär deaktiviert sind, zu schaffen, die das elektronische Gerät nach einem Signalflankenwechsel eines Schaltsignals, d. h. bei fallender oder steigender Flanke, in einen aktiven Zustand überführt, ohne im Bereitschaftsbetrieb bzw. Ruhezustand des elektronischen Geräts selbst Energie aufzunehmen.

Diese Aufgabe wird erfindungsgemäß durch die Merkmale des Hauptanspruchs gelöst.

Durch die in den Unteransprüchen angegebenen Maßnahmen sind vorteilhafte Weiterbildungen und Verbesserungen möglich.

Erfindungsgemäß umfasst die Vorrichtung zum Aktivieren eines elektronischen Geräts eine erste Triggerschaltung, die ausgebildet ist, bei einem an einem Schalteingang liegenden Schaltsignal mit einer positiven Flanke ein erstes Triggersignal abzugeben, eine zweite Triggerschaltung, die ausgebildet ist, bei einem Schaltsignal mit einer negativen Flanke ein zweites Triggersignal abzugeben, eine Ausgangsschaltung, die ausgebildet ist, abhängig von dem ersten Triggersignal ein Wecksignal zu erzeugen, das vom Energiespeicher geliefert wird, eine Selbsthalteschaltung, die ausgebildet ist, das Wecksignal zu halten, und eine Resetschaltung, die ausgebildet ist, das Wecksignal abzuschalten, wobei die erste Triggerschaltung ausgebildet ist, auch abhängig vom zweiten Triggersignal ein erstes Triggersignal abzugeben. Durch die erfindungsgemäße Vorrichtung wird eine mit elektronischen Bauteilen diskret aufgebaute Schaltung zur Verfügung gestellt, die auf steigende und fallende Spannungsflanken an ihrem Eingang reagiert und die keine Energie im Ruhezustand benötigt. Die durch den Schaltkontakt am Schalteingang vorgegebenen Schaltereignisse werden ausgegeben und gespeichert, so dass ein vom Ausgang der Ausgangsschaltung versorgtes Steuergerät aktiviert wird und bleibt, bis die Schalterereignisse durch die Resetschaltung zurückgesetzt werden.

Im bevorzugten Ausführungsbeispiel weist die erste Triggerschaltung einen ersten Transistor auf, dessen Steuerelektrode abhängig vom Schaltsignal mit positiver Flanke oder vom zweiten Triggersignal zur Abgabe des ersten Triggersignals steuerbar ist. Vorzugsweise wird somit der erste Transistor, der beispielsweise als Feldeffekttransistor ausgebildet sein kann, z. B. als MOSFET, bei Auftreten eines positiven Potentials an der Steuerelektrode leitend geschaltet, wobei das positive Potential sowohl vom Schaltsignal als auch von der zweiten Triggerschaltung geliefert werden kann.

In vorteilhafter Weise umfasst die Triggerschaltung einen Kondensator, der abhängig vom Schaltsignal mit der positiven Flanke aufladbar ist und mit dem Schalteingang und der Steuerelektrode des ersten Transistors verbunden ist. Der Kondensator dient als Gleichstromsperre, d. h., es wird ein unerwünschter Stromfluss verhindert.

Entsprechend dem bevorzugten Ausführungsbeispiel hat die zweite Triggerschaltung einen zweiten Transistor, dessen Steuerelektrode abhängig vom Schaltsignal mit negativer Flanke zur Abgabe des zweiten Triggersignals steuerbar ist. Wenn der Schaltkontakt öffnet, nachdem die Weckvorrichtung zurückgesetzt wurde und somit kein Wecksignal anstand, wird der zweite Transistor durchgeschaltet, wodurch ein zweites Triggersignal erzeugt wird, das wiederum den ersten Transistor leitend schaltet. Der zweite Transistor kann dabei als bipolarer Transistor (P-N-P-Transistor) ausgebildet sein.

Vorzugsweise weist die zweite Triggerschaltung ebenfalls einen Kondensator auf, der abhängig vom Schaltsignal mit der negativen Flanke aufladbar ist und mit dem Schalteingang und der Steuerelektrode des zweiten Transistors verbunden ist. Auch hier werden Gleichströme abgeblockt und kein unerwünschter Stromfluss zum zweiten Transistor zugelassen.

Im bevorzugten Ausführungsbeispiel umfasst die Ausgangsschaltung einen dritten Transistor, dessen Steuerelektrode mit dem ersten Transistor der ersten Triggerschaltung verbunden ist. Dadurch wird der dritte Transistor beim Durchschalten des ersten Transistors leitend, derart, dass am Ausgang der Ausgangsschaltung das Wecksignal anliegt, das über den durchgeschalteten dritten Transistor vom Energiespeicher geliefert wird. Der dritte Transistor ist vorzugsweise ein Bipolartransistor (P-N-P-Transistor).

Vorzugsweise weist die Selbsthalteschaltung eine Diode auf, die einerseits mit dem das Wecksignal liefernden Ausgang der Ausgangsschaltung und andererseits mit der Steuerelektrode des ersten Transistors verbunden ist. Durch die Rückkopplung des Wecksignals über die Diode an die Steuerelektrode des ersten Transistors wird ein Potential zur Verfügung gestellt, das den ersten Transistor durchgeschaltet hält.

Erfindungsgemäß weist die Resetschaltung einen vierten Transistor auf, dessen Steuereingang mit einem Eingang eines Resetsignals und dessen gesteuerte Elektrode mit der Steuerelektrode des ersten Transistors verbunden ist. Durch das Resetsignal, das als Spannungsimpuls ausgebildet sein kann, wird der vierte Transistor leitend geschaltet, was durch Absenken des Potentials an der Steuerelektrode des ersten Transistors zur Sperrung des ersten Transistors und damit des dritten Transistors führt.

Entsprechend der Erfindung ist der Anschluss für den Energiespeicher, d. h. der Versorgungsanschluss der erfindungsgemäßen Vorrichtung mit dem zweiten und dem dritten Transistor verbunden, wodurch die entsprechenden Potentialbedingungen erfüllt werden.

Der Schalteingang für das Schaltsignal ist mit einem Eingangsfilter aus parallel geschaltetem Kondensator und Widerstand verbunden, das hochfrequente Störsignale durch Prellen des Schaltkontaktes oder dergleichen ausfiltert.

Die Erfindung ist der Zeichnung dargestellt und wird in der nachfolgenden Beschreibung näher erläutert. Es zeigen:
- Fig. 1: ein Blockschaltbild der erfindungsgemäßen Vorrichtung,
- Fig. 2: die schaltungsgemäße diskrete Ausführung der erfindungsgemäßen Vorrichtung und
- Fig. 3: ein Zeitdiagramm der möglichen Signale der erfindungsgemäßen Schaltung.

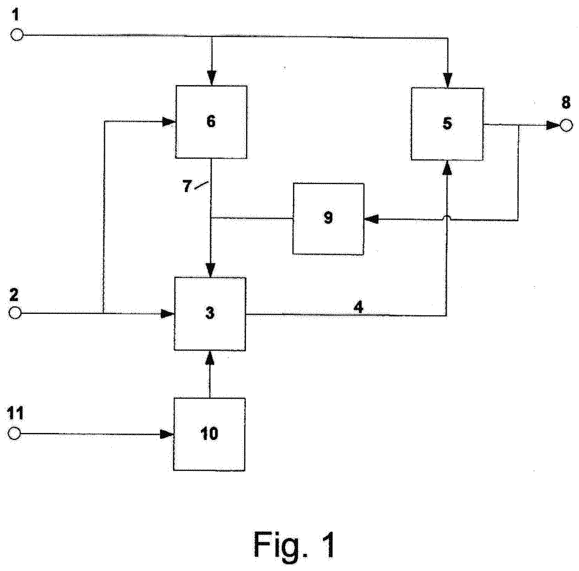

In Fig. 1 ist ein Blockschaltbild der erfindungsgemäßen Vorrichtung zum Aktivieren eines elektronischen Geräts gezeigt, wobei es sich im Ausführungsbeispiel um ein Steuergerät in einem Fahrzeug handelt. Dabei weist die Vorrichtung einen Spannungsversorgungsanschluss 1 auf, an dem beispielsweise eine Batterie oder ein Akkumulator oder ein sonstiger Energiespeicher anschließbar ist, im vorliegenden Fall wird angenommen, dass an dem Anschluss eine Batteriespannung U_{B} anliegt. Mit 2 ist ein Schalteingang bezeichnet, der mit einem Schaltkontakt verbunden ist, wobei der eine Anschluss des Schaltkontakts am Schalteingang 2 und der andere Anschluss an der Batteriespannung bzw. an einer von der Batteriespannung abhängigen herabgesetzten Spannung liegt. Der Schaltkontakt kann beispielsweise ein Türkontakt oder jedweder andere Kontakt sein.

Der Schaltkontakt ist mit einer ersten Triggerschaltung 3 verbunden, die an ihrem Ausgang ein Triggersignal 4 erzeugt, das an eine Ausgangsschaltung 5 geleitet wird. Weiterhin ist der Schalteingang 2 mit einer zweiten Triggerschaltung 6 verbunden, die ein zweites Triggersignal 7 liefert, wobei dieses zweite Triggersignal der ersten Triggerschaltung 3 zugeführt wird.

Am Ausgang der Ausgangsschaltung 5 liegt als Ausgangssignal ein Wecksignal 8, das einem nachgeschalteten Steuergerät zugeführt wird, damit dieses aktiviert bzw. mit einer Spannung versorgt wird. Eine Selbsthalteschaltung 9 ist mit dem Ausgang der Ausgangsschaltung 5 und mit der ersten Triggerschaltung 3 verbunden. Eine Resetschaltung 10 mit einem Reseteingang 11 ist mit der ersten Triggerschaltung 3 verbunden und setzt diese zurück.

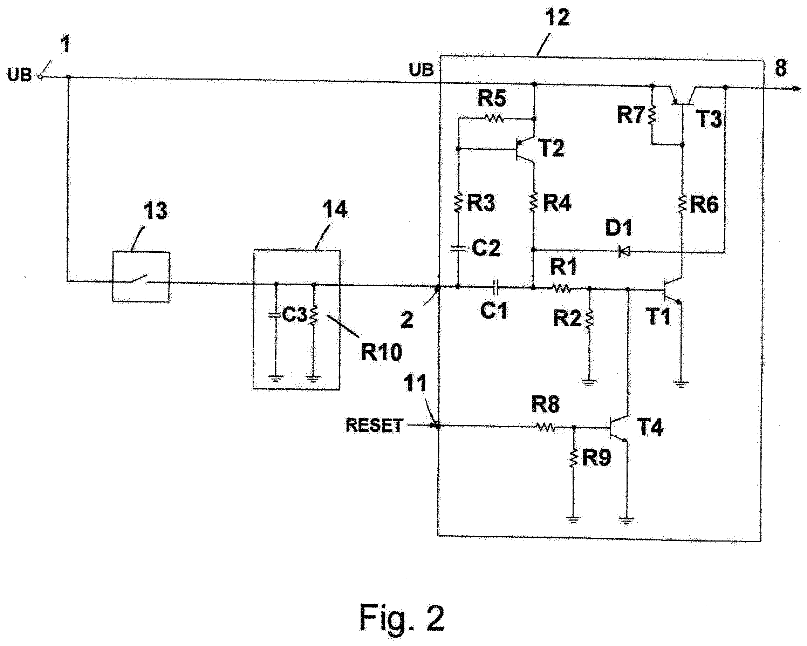

In Fig. 2 ist die Schaltung nach Fig. 1 detaillierter dargestellt, wobei die eigentliche Weckschaltung 12 mit diskreten Bauteilen gezeigt ist, und zusätzlich dazu sind ein Schaltkontakt 13 und ein Eingangsfilter 14 vorgesehen. Der Schaltkontakt 13 ist mit dem Spannungsversorgungs- bzw. Batterieanschluss 1 und über das Eingangsfilter 14 mit dem Schalteingang 2 verbunden. Der Schaltkontakt 13 ist über einen Kondensator C1 und einen Widerstand R1 an die Steuerelektrode eines Transistors T1 angeschlossen, der hier als Bipolar-Transistor dargestellt ist, jedoch auch als MOSFET oder als ein entsprechender Transistor ausgebildet sein kann. Der Widerstand R1 ist Bestandteil eines Spannungsteilers R1/R2, wobei der Widerstand R2 an Masse liegt. Der Transistor T1 ist als N-P-N-Transistor ausgeführt und der Emitter ist mit Masse verbunden. Die Bauteile C1, R1, R2 und T1 stellen die erste Triggerschaltung 3 gemäß Fig. 1 dar.

Der Schalteingang 2 ist ebenfalls über einen Kondensator C2 und einen Widerstand R3 mit der Steuerelektrode eines zweiten Transistors T2 verbunden, der als P-N-P-Bipolar-Transistor ausgeführt ist, wobei der Emitter am Batterieanschluss 1 liegt und der Kollektor über einen Widerstand R4 an den Knotenpunkt zwischen dem Kondensator C1 und dem Widerstand R1 angeschlossen ist. Ein Widerstand R5 liegt zwischen Kollektor und Basis des Transistors T2. Die Widerstände R3, R4 und R5 dienen zur Arbeitspunkteinstellung des Transistors T2. Der Kondensator C2, die Widerstände R3, R4, R5 und der Transistor T2 bilden die zweite Triggerschaltung.

Der Kollektor des Transistors T1 ist über einen Widerstand R6 mit der Steuerelektrode eines dritten Transistors T3 verbunden, der als P-N-P-Bipolartransistor ausgeführt ist und dessen Kollektor den Ausgang der Weckschaltung 12 darstellt, an dem das Wecksignal 8 anliegt. Ein Widerstand R7 liegt zwischen Emitter und Basis des Transistors T3. Die Widerstände R6, R7 und der Transistor T3 stellen die Ausgangsschaltung 5 dar.

Schließlich ist eine Rückführung vom Ausgang des Transistors T3 bzw. der Weckschaltung 12 zum Knotenpunkt zwischen dem Kondensator C1 und dem Widerstand R1 über eine Diode D1 vorgesehen, wobei Rückführung und Diode D1 die Selbsthalteschaltung 8 bilden. Schließlich weist die Weckschaltung 12 noch den Reseteingang 11 für ein Resetsignal auf, wobei dieser Eingang über den Widerstand R8 mit der Steuerelektrode eines Transistors T4 verbunden ist. Der Widerstand R8 ist Bestandteil eines Spannungsteilers R8, R9, letzterer Widerstand ist mit Masse verbunden. Der Transistor T4 ist als N-P-N-Bipolar-Transistor ausgebildet und sein Kollektor ist mit der Steuerelektrode des Transistors 1 verbunden, während der Emitter auf Masse liegt.

Im Folgenden soll die Funktionsweise der Schaltung nach Fig. 1 und Fig. 2 erläutert werden. Es wird von einer Ausgangssituation ausgegangen, bei der das nicht dargestellte Steuergerät im Bereitschaftsmodus bzw. im Ruhezustand ist, die Spannung des Wecksignals beträgt ca. 0 V, d. h., es ist kein Wecksignal vorhanden, der Schaltkontakt 13 ist geöffnet und die Transistoren T1 bis T4 sperren. In diesem Zustand nimmt die Weckschaltung 12 keine Energie auf. Wenn nun der Schaltkontakt, der beispielsweise ein Türkontakt sein kann, geschlossen wird, tritt eine positive Spannungsflanke auf, wobei die Spannungsflanke und entsprechend dann die Spannung U_{B} am Schalteingang liegt. Dabei filtert das Eingangsfilter, das aus einer Parallelschaltung eines Kondensators C3 und eines Widerstands R10 besteht, Prellungen des Schaltkontaktes 13 und elektromagnetische Störungen weg. Da an der Steuerelektrode des Transistors T1 ein positives Potential liegt, beginnt der Transistor T1 zu leiten, während sich der Kondensator C1 auflädt. Über den leitenden Transistor T1 und den Widerstand R6, der zusammen mit dem Widerstand R7 zur Arbeitspunkteinstellung des Transistors T3 dient, liegt ein Spannungspotential an der Basis T3 an, durch das der Transistor T3 leitend wird und die Spannung des Wecksignals 8 auf U_{B} ansteigt. Selbstverständlich können in der Leitung zwischen Batterieanschluss 1 und Ausgang der Weckschaltung 12 weitere Bauteile vorgesehen sein, die die Spannung des Wecksignals 8 beeinflussen. Aufgrund des Wecksignals 8 werden nun nachfolgende Schaltungsteile, wie ein nachgeschaltetes Steuergerät, aktiviert. Die Weckschaltung kann auch beispielsweise die eigentliche Stromversorgung von nachfolgenden Steuergeräten zustarten.

Währenddessen ist der Kondensator C1 vollständig aufgeladen und es erfolgt keine Energieaufnahme über den Schalteingang 2 der Weckschaltung 12. Damit der Transistor T1 nicht sperrt und damit das Wecksignal 8 am Ausgang nicht auf 0 V abfällt, wird dieses Wecksignal über die Diode D1 auf den Spannungsteiler R1/R2 zurückgekoppelt, was zu einer Selbsthaltung des Transistors T1 bzw. zum Halten und damit zur Signalspeicherung des Wecksignals führt.

Nachdem die nachfolgenden Schaltungsteile bzw. das Steuergerät durch das Wecksignal 8 aktiviert wurden, wird an den Reseteingang 11 ein Reset-Spannungsimpuls angelegt, der den Transistor T4 leitend werden lässt, wobei auch hier die Widerstände R8 und R9 zur Arbeitspunkteinstellung dienen, wodurch das Spannungspotential an der Steuerelektrode des Transistors T1 auf Masse gelegt wird und er dadurch sperrt. Daraufhin sperrt auch der Transistor T3 und das Wecksignal 8 fällt auf ca. 0 V ab. Ab diesem Zeitpunkt nimmt die Weckschaltung 12 keine Energie mehr auf. Nach einer gewissen Zeit, d. h. nachdem es seine Aufgabe oder Funktion erfüllt hat, geht das Steuergerät wieder in den Bereitschaftsmodus bzw. den Ruhezustand.

Irgendwann öffnet der Schaltkontakt 13 wieder, dies ist z. B. der Fall, wenn eine Autotür über Nacht in der Garage geschlossen ist und am nächsten Tag die Tür geöffnet wird, wodurch auch der Schaltkontakt 13 öffnet. Aufgrund der Potentialverhältnisse an der Basis des Transistors T2 beginnt dieser zu leiten, während sich der Kondensator C2 auflädt. Über den Transistor T2 und den Widerstand R4 bzw. den Widerstand R1 liegt ein positives Potential an der Steuerelektrode des Transistors T1, so dass dieser leitend wird und daraufhin auch der Transistor T3 leitend wird, wodurch die Spannung des Wecksignals 8 wieder auf U_{B} ansteigt und z. B. das nachfolgende Steuergerät aktiviert. Währenddessen ist der Kondensator C2 vollständig aufgeladen, und der Transistor T2 sperrt wieder. Aufgrund der Selbsthalteschaltung über die Rückführung vom Ausgangssignal des Transistors T3 und die Diode D1 auf den Knotenpunkt zwischen dem Kondensator C1 und dem Widerstand R1 wird der Transistor T1 leitend gehalten und das Wecksignal bleibt auf Batteriespannung und fällt nicht auf 0 V ab.

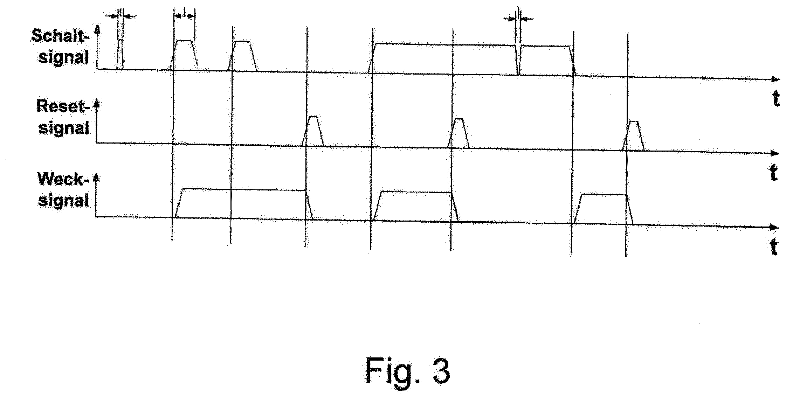

In Fig. 3 sind Signaldiagramme der erfindungsgemäßen Vorrichtung dargestellt, wobei die oberste Reihe das Schaltsignal dargestellt, die mittlere Reihe das Resetsignal und die untere Reihe das Wecksignal zeigen. Damit ein kurzer Impuls, wie er als erster Impuls in der obersten Reihe für ein Schaltsignal gezeigt ist, nichts aktiviert, ist eine nicht dargestellte Verzögerungsschaltung vorgesehen, die einen kurzen Impuls unterdrückt. Der zweite Impuls mit seiner positiven Flanke aktiviert die Weckschaltung und erzeugt ein Wecksignal, wie es in der untersten Zeile gezeigt ist. Auch wenn das Schaltsignal abfällt, bleibt das Wecksignal aktiviert, da die Selbsthaltung über die Selbsthalteschaltung 9 wirkt.

In entsprechender Weise wird auch bei einem neuen Schaltimpuls die Wecksignalschaltung 12 nicht verändert, da sie noch aktiviert ist. Erst wenn ein Resetsignal an den Reseteingang 11 angelegt wird, fällt das Wecksignal ab, wie in der zweiten und dritten Zeile zu erkennen ist. Wiederum wird in der obersten Zeile der Schaltkontakt geschlossen und es liegt ein Schaltsignal an, worauf das Wecksignal erzeugt wird. Anschließend wird ein Resetsignal erzeugt, das das Wecksignal auf 0 fallen lässt, während in der obersten Zeile weiterhin der Schaltkontakt geschlossen bleibt. Selbst bei einer kurzen Unterbrechung wird dies ignoriert, wobei das Ignorieren von kurzzeitigen Unterbrechungen von der Dimensionierung der Kondensatoren, die sich über das Eingangsfilter 1 entladen können, und Widerständen abhängt. Mit der negativen Flanke wird wiederum das Wecksignal, das zuvor auf 0 V liegt, auf Batteriespannung angehoben, was auf der untersten Zeile beim letzten Impuls zu sehen ist. Dieser wird dann wieder durch den Reset auf 0 zurückgeführt.

## Patentansprüche

1. Vorrichtung zum Aktivieren eines elektronischen Geräts, insbesondere eines Steuergeräts in einem Fahrzeug, das von einem Ruhezustand in einen Betriebszustand versetzbar ist, bei dem das Gerät von einem Energiespeicher versorgt wird, wobei das Aktivieren abhängig von einem mit dem Energiespeicher verbundenen Schaltkontakt erfolgt, mit
einer ersten Triggerschaltung (3), die ausgebildet ist, bei einem an einem Schalteingang (2) liegenden Schaltsignal mit einer positiven Flanke ein erstes Triggersignal (4) abzugeben,
einer Ausgangsschaltung (5), die ausgebildet ist, abhängig von dem ersten Triggersignal (4) ein Wecksignal (8) zu erzeugen, das vom Energiespeicher geliefert wird, einer Selbsthalteschaltung (9), die ausgebildet ist, das Wecksignal (8) zu halten,
einer Resetschaltung (10), die ausgebildet ist, das Wecksignal (8) abzuschalten,
**gekennzeichnet durch**
eine zweite Triggerschaltung (6), die ausgebildet ist, bei einem Schaltsignal (2) mit einer negativen Flanke ein zweites Triggersignal (7) abzugeben, wobei die erste Triggerschaltung (3) ausgebildet ist, auch abhängig vom zweiten Triggersignal (7) ein erstes Triggersignal (4) zu liefern.

2. Vorrichtung nach Anspruch 1, **dadurch gekennzeichnet, dass** die erste Triggerschaltung (3) einen ersten Transistor (T1) aufweist, dessen Steuerelektrode abhängig vom Schaltsignal mit positiver Flanke oder vom zweiten Triggersignal zur Abgabe des ersten Triggersignals steuerbar ist.

3. Vorrichtung nach Anspruch 2, **dadurch gekennzeichnet, dass** die erste Triggerschaltung (3) einen Kondensator (C1) aufweist, der abhängig vom Schaltsignal mit der positiven Flanke aufladbar ist und mit dem Schalteingang (2) und der Steuerelektrode des ersten Transistors (T1) verbunden ist.

4. Vorrichtung nach einem der Ansprüche 1 bis 3, d a - **durch gekennzeichnet,** dass die zweite Triggerschaltung (6) einen zweiten Transistor (T2) aufweist, dessen Steuerelektrode abhängig vom Schaltsignal mit negativer Flanke zur Abgabe des zweiten Triggersignals steuerbar ist.

5. Vorrichtung nach Anspruch 4, **dadurch ge** - **kennzeichnet,** dass die zweite Triggerschaltung (6) einen Kondensator (C2) aufweist, der abhängig vom Schaltsignal mit der negativen Flanke aufladbar ist und mit dem Schalteingang und der Steuerelektrode des zweiten Transistors (T2) verbunden ist.

6. Vorrichtung nach einem der Ansprüche 1 bis 5, d a - **darduch gekennzeichnet,** dass die Ausgangsschaltung (5) einen dritten Transistors (T3) aufweist, dessen Steuerelektrode mit dem ersten Transistor (T1) der ersten Triggerschaltung (3) verbunden ist.

7. Vorrichtung nach einem der Ansprüche 1 bis 6, d a - **darduch gekennzeichnet,** dass die Selbsthalteschaltung (9) eine Diode (D1) aufweist, die einerseits mit dem das Wecksignal liefernden Ausgang der Ausgangsschaltung (5) und andererseits mit der Steuerelektrode des ersten Transistors (T1) verbunden ist.

8. Vorrichtung nach einem der Ansprüche 1 bis 7, d a - **darduch gekennzeichnet,** dass die Resetschaltung (10) einen vierten Transistor (T4) aufweist, dessen Steuerelektrode mit einem Eingang (11) eines Resetsignals und dessen gesteuerte Elektrode mit der Steuerelektrode des ersten Transistors (T1) verbunden ist.

9. Vorrichtung nach einem der Ansprüche 1 bis 8, d a - **darduch gekennzeichnet,** dass ein Anschluss (1) für den Energiespeicher mit dem zweiten Transistor (T2) und dem dritten Transistor (T3) verbunden ist.

## Claims

1. Apparatus for activating an electronic device, in particular a control device in a vehicle, which can be transferred from an idle state to an operating state, in which the device is supplied with power by an energy store, wherein the activation is effected depending on a switching contact connected to the energy store, having
a first trigger circuit (3), which is designed to emit a first trigger signal (4) in the case of a switching signal with a positive edge present at a switching input (2),
an output circuit (5), which is designed to generate a wake signal (8) depending on the first trigger signal (4), said wake signal being provided by the energy store,
a self-latching circuit (9), which is designed to latch the wake signal (8),
a reset circuit (10), which is designed to disconnect the wake signal (8),
**characterized by**
a second trigger circuit (6), which is designed to emit a second trigger signal (7) in the case of a switching signal (2) with a negative edge, wherein the first trigger circuit (3) is designed to also provide a first trigger signal (4) depending on the second trigger signal (7).

2. Apparatus according to Claim 1, **characterized in that** the first trigger circuit (3) has a first transistor (Tl), the control electrode of which can be controlled depending on the switching signal with a positive edge or on the second trigger signal for emitting the first trigger signal.

3. Apparatus according to Claim 2, **characterized in that** the first trigger circuit (3) has a capacitor (Cl), which can be charged depending on the switching signal with the positive edge and is connected to the switching input (2) and the control electrode of the first transistor (T1).

4. Apparatus according to one of Claims 1 to 3, **characterized in that** the second trigger circuit (6) has a second transistor (T2), the control electrode of which can be controlled depending on the switching signal with a negative edge for emitting the second trigger signal.

5. Apparatus according to Claim 4, **characterized in that** the second trigger circuit (6) has a capacitor (C2), which can be charged depending on the switching signal with the negative edge and is connected to the switching input and the control electrode of the second transistor (T2).

6. Apparatus according to one of Claims 1 to 5, **characterized in that** the output circuit (5) has a third transistor (T3), the control electrode of which is connected to the first transistor (T1) of the first trigger circuit (3).

7. Apparatus according to one of Claims 1 to 6, **characterized in that** the self-latching circuit (9) has a diode (Dl), which, on the one hand, is connected to the output of the output circuit (5) providing the wake signal and, on the other hand, to the control electrode of the first transistor (T1).

8. Apparatus according to one of Claims 1 to 7, **characterized in that** the reset circuit (10) has a fourth transistor (T4), the control electrode of which is connected to an input (11) of a reset signal and the controlled electrode of which is connected to the control electrode of the first transistor (T1).

9. Apparatus according to one of Claims 1 to 8, **characterized in that** a connection (1) for the energy store is connected to the second transistor (T2) and the third transistor (T3).

## Revendications

1. Dispositif pour activer un appareil électronique, notamment un contrôleur dans un véhicule, lequel peut être amené d'un état de repos à un état opérationnel, avec lequel l'appareil est alimenté par un accumulateur d'énergie, l'activation s'effectuant en fonction d'un contact de commutation relié à l'accumulateur d'énergie, comprenant un premier circuit de déclenchement (3) qui est configuré pour délivrer un premier signal de déclenchement (4) en présence d'un signal de commutation ayant un front positif appliqué à une entrée de commutation (2),
un circuit de sortie (5) qui est configuré pour générer, en fonction du premier signal de déclenchement (4), un signal de réveil (8) qui est délivré par l'accumulateur d'énergie,
un circuit d'auto-maintien (9) qui est configuré pour maintenir le signal de réveil (8),
un circuit de réinitialisation (10) qui est configuré pour désactiver le signal de réveil (8),
**caractérisé par**
un deuxième circuit de déclenchement (6) qui est configuré pour délivrer un deuxième signal de déclenchement (7) en présence d'un signal de commutation (2) ayant un front négatif, le premier circuit de déclenchement (3) étant configuré pour délivrer un premier signal de déclenchement (4) également en fonction du deuxième signal de déclenchement (7).

2. Dispositif selon la revendication 1, **caractérisé en ce que** le premier circuit de déclenchement (3) possède un premier transistor (T1) dont l'électrode de commande peut être commandée en fonction du signal de commutation ayant un front positif ou du deuxième signal de déclenchement en vue de délivrer le premier signal de déclenchement.

3. Dispositif selon la revendication 2, **caractérisé en ce que** le premier circuit de déclenchement (3) possède un condensateur (C1) qui peut être chargé en fonction du signal de commutation ayant un front positif et qui est relié à l'entrée de commutation (2) et à l'électrode de commande du premier transistor (T1).

4. Dispositif selon l'une des revendications 1 à 3, **caractérisé en ce que** le deuxième circuit de déclenchement (6) possède un deuxième transistor (T2) dont l'électrode de commande peut être commandée en fonction du signal de commutation ayant un front négatif en vue de délivrer le deuxième signal de déclenchement.

5. Dispositif selon la revendication 4, **caractérisé en ce que** le deuxième circuit de déclenchement (6) possède un condensateur (C2) qui peut être chargé en fonction du signal de commutation ayant un front négatif et qui est relié à l'entrée de commutation et à l'électrode de commande du deuxième transistor (T2).

6. Dispositif selon l'une des revendications 1 à 5, **caractérisé en ce que** le circuit de sortie (5) possède un troisième transistor (T3) dont l'électrode de commande est reliée au premier transistor (T1) du premier circuit de déclenchement (3).

7. Dispositif selon l'une des revendications 1 à 6, **caractérisé en ce que** le circuit d'auto-maintien (9) possède une diode (D1) qui est reliée d'un côté à la sortie délivrant le signal de réveil du circuit de sortie (5) et de l'autre côté à l'électrode de commande du premier transistor (T1).

8. Dispositif selon l'une des revendications 1 à 7, **caractérisé en ce que** le circuit de réinitialisation (10) possède un quatrième transistor (T4) dont l'électrode de commande est reliée à une entrée (11) d'un signal de réinitialisation et dont l'électrode commandée est reliée à l'électrode de commande du premier transistor (T1).

9. Dispositif selon l'une des revendications 1 à 8, **caractérisé en ce qu'**une borne (1) pour l'accumulateur d'énergie est reliée au deuxième transistor (T2) et au troisième transistor (T3).
